# EUROPEAN PATENT APPLICATION

(11) **EP 4 435 837 A1**
(43) Date of publication of application: **25.09.2024**
(21) Application number: 23162997.3
(22) Date of filing: 20.03.2023
(51) Int. Cl.: H01L 21/67

(54) **PICK-AND-PLACE APPARATUS AND METHOD**

(71) Applicant: Nexperia B.V., 6534 AB Nijmegen (NL)
(72) Inventor: Ellenbroek, Tim, Nijmegen (NL); Verstoep, Steven, Nijmegen (NL); de Koning, Niels, Nijmegen (NL)
(74) Representative: Pjanovic, Ilija

(57) **Abstract**

Aspects of the present disclosure relate to a method for transferring a plurality of electrical components from a source substrate to a plurality of empty positions on a target substrate. Further aspects of the present disclosure relate to an apparatus for carrying out this method and to a corresponding computer program product.

According to an aspect of the present disclosure a binning map is constructed of the source substrate by assigning each electrical component among the plurality of electrical components to a respective bin among M bins based on one or more parameters of the electrical components. The target substrate is divided into a plurality of unit cells, wherein each unit cell comprises a plurality of component positions, each component position being associated with a respective bin among the plurality of bins. The electrical components are arranged on the target substrate such that, at each component position of each unit cell, an electrical component from the source substrate is arranged that is assigned to the same bin as the bin that is associated with that component position.

## Description

### FIELD

Aspects of the present disclosure relate to a method for transferring a plurality of electrical components from a source substrate to a plurality of empty positions on a target substrate. Further aspects of the present disclosure relate to an apparatus for carrying out this method and to a corresponding computer program product.

### BACKGROUND

Light-emitting diodes, LEDs, can be placed on a target substrate to form a display panel. An example of such a panel is a panel in which the LEDs can be individually controlled for generating a pattern or an image. Typically, for manufacturing such a display panel, light-emitting diodes in the form of packaged or bare semiconductor dies are collected from a source substrate that comprises packaged or bare semiconductor dies. The source substrate can for example have the form of a diced semiconductor wafer, in which all semiconductor dies originate from the same semiconductor wafer, or can have the form of a structured wafer, in which the semiconductor dies originate from different semiconductor wafers.

Light-emitting diodes can be characterized by the wavelength or color, and intensity of the emitted light. Typically, these parameters show a non-uniform distribution over the wafer. For example, the wafer may have `best' areas holding semiconductor dies that display a particular desired performance and 'worst' areas holding semiconductor dies that display a performance that is different from the desired performance. These latter areas can typically be found around the edge of the wafer.

The process of collecting LEDs, or other electrical components, from the source substrate and placing the collected LEDs on a target substrate is known as a pick-and-place process and the apparatus used for performing this process is referred to as a pick-and-place apparatus.

Known pick-and-place apparatuses comprise a source carrier, such as a moveable source table, configured to hold a source substrate that comprises a plurality of electrical components such as the abovementioned LEDs. These apparatuses further comprise a target carrier, such as a moveable target table, configured to hold a target substrate, and a transport system for collecting an electrical component from the source substrate and for arranging the selected electrical component on the target substrate. The transport system may comprise a source drive for moving the source carrier and a target drive for moving the target carrier. Known pick-and-place apparatuses further comprise a controller for controlling the transport system. For example, the controller can be configured to control the source drive and the target drive.

In high-throughput pick-and-place apparatuses, the transport system is often configured to collect each electrical component from the source substrate at a same collect position in space. Furthermore, the transport system is often configured to arrange each collected electrical component on the substrate at a same placement position in space. In this case, the controller can be configured to control the source drive and/or target drive to repeatedly position an electrical component on the source substrate at the collect position and/or to repeatedly position an empty position on the target substrate at the placement position.

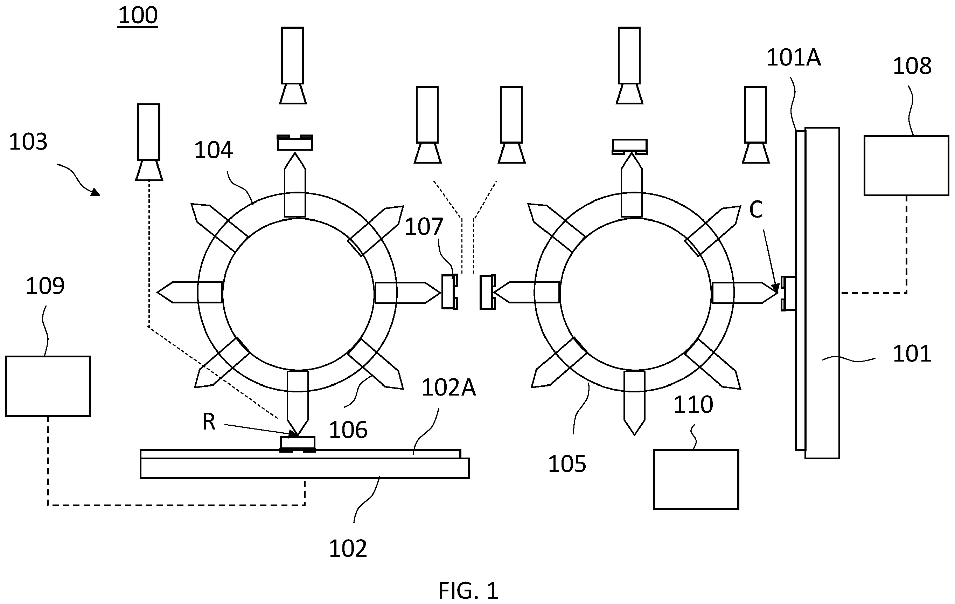

A schematic illustration of a known pick-and-place apparatus 100 is shown in figure 1. Here, the source carrier and target carrier are referred to using reference signs 101 and 102, respectively. For illustrative purposes, source carrier 101 is shown supporting a source substrate 101A that holds a single electrical component 107, and target carrier 102 is shown supporting a target substrate 102A holding a single electrical component 107. Furthermore, source carrier 101 and target carrier 102 can be actuated using a source drive 108 and a target drive 109, respectively, which are part of a transport system 103.

Transport system 103 further comprises two cylinders or drums 104, 105 on which vacuum units 106 are mounted that are each configured for holding an electrical component 107 by means of vacuum. By rotating drum 105, an empty vacuum unit 106 can be positioned at or near a collect position C in the vicinity of source substrate 101A holding an electrical component 107. For example, a diced semiconductor wafer can be arranged on a dicing foil, and this combination can be arranged on source carrier 101.

By applying the vacuum, an electrical component 107 can be collected from source substrate 101A. By subsequently rotating drum 105, collected electrical component 107 can be brought into the vicinity of a vacuum unit 106 of drum 104. Here, a hand-over may occur between drum 105 and drum 104. This can for example be achieved by switching off the vacuum for the vacuum unit 106 of drum 105 and by switching on or maintaining the vacuum for the vacuum unit 106 of drum 104. The hand-over between drum 105 and drum 104 allows electrical component 107 to be flipped.

For arranging the electrical component on target substrate 102A, drum 104 is rotated until it reaches or comes close to a predefined placement position R. At this position, the vacuum can be switched off allowing electrical component 107 to fall at a desired position on target substrate 102A.

In this example, drum 104 and drum 105 are rotationally mounted. The required movement for collecting all the semiconductor dies from the semiconductor wafer is achieved using source carrier 101, which is typically configured to move in two orthogonal directions in a plane that is parallel to semiconductor wafer 101A. On the other hand, the required movement for placing all the semiconductor dies on target substrate 102A is achieved using target carrier 102, which is typically configured to move in two orthogonal directions in a plane that is parallel to target substrate 102A. Furthermore, collect position C and placement position R are typically fixed in space.

For the implementing the abovementioned pick-and-place process, pick-and-place apparatus 100 comprises a controller for controlling transport system 103.

In the known pick-and-place process, a serpentine process is used for collecting the electrical components from the carrier. In a serpentine process, the source carrier is moved such that the order in which the electrical components are collected corresponds to a serpentine shape on the source substrate. For example, the source carrier first makes a right-to-left motion to allow the electrical components in a same row to be collected, and then makes a shift up or down to move to a next row of electrical components. This row is then collected by making a left-to-right motion, after which another shift is performed to move to the next row allowing the process described above to be repeated.

An advantage of the serpentine process is that this process offers a very high throughput. This is related to the minimal movements of the source carrier, which is generally a relatively heavy component. A drawback of the serpentine process is related to the fact that the nonuniformity in device performance of the electrical components on the source substrate is transferred to the target substrate.

Typically, the performance of the electrical components is determined after manufacturing. For example, the color and/or intensity of each LED on a diced semiconductor wafer can be determined and/or measured. This results in a so-called wafer map that describes one or more parameters of the semiconductor dies as a function of the position of these semiconductor dies on the wafer.

A known example to address the uniformity problem of components on the substrate is to use a robotic arm to pick-and-place the electrical components. Using such robotic arm, and based on the wafer map, a somewhat random distribution of electrical components on the target substrate can be realized. However, using a robotic arm does not allow for a high throughput to be achieved.

### SUMMARY

Aspects of the present disclosure relate to a method for transferring a plurality of electrical components from a source substrate to a plurality of empty positions on a target substrate. This method comprises the steps of constructing a binning map of the source substrate by assigning each electrical component among the plurality of electrical components to a respective bin among M bins based on one or more parameters of the electrical components, wherein M is greater than 1. The method further comprises dividing the target substrate into a plurality of unit cells, wherein each unit cell comprises a plurality of component positions, each component position being associated with a respective bin among the plurality of bins. The electrical components are then arranged on the target substrate such that, at each component position of each unit cell, an electrical component from the source substrate is arranged that is assigned to the same bin as the bin that is associated with that component position.

The method in accordance with the present disclosure allows for high uniformities to be achieved on the target substrate while introducing little to no reduction in throughput. For example, the relatively heavy source carrier can perform similar movements during the pick-and-place process as is known from the prior art.

Constructing a binning map of the source substrate may comprise measuring one or more parameters of each electrical component among the plurality of components on the source substrate. Examples of such parameters are an electrical resistance, a frequency, wavelength, or colour point of light emitted by the component during operation, and a forward voltage of the component.

For each electrical component among the plurality of components measurement values of the one or more parameters are compared to a plurality of ranges for the one or more parameters. Each range is associated with a respective bin among the plurality of bins. Next, the electrical component is associated to that bin of which the ranges for the one or more parameters cover the measurement values of the one or more parameters.

As an example, two parameters A and B can be measured for each electrical component. Bins may be constructed based on ranges [10-20], [20-30] for parameter A, and ranges [1-3], [3-6] for parameter B. This allows four bins to be constructed, bin 1 corresponding to [10-20] and [1-3], bin 2 corresponding to [20-30] and [1-3], bin 3 corresponding to [10-20] and [3-6], and bin 4 corresponding to [20-30] and [3-6]. The table below illustrates the process of assigning electrical components to bins 1-4 based on measurement values for parameters A and B.

| Component no: | Measurement A | Measurement B | Bin |
|---|---|---|---|
| 1 | 11.2 | 2.5 | 1 |
| 2 | 26.3 | 3.1 | 4 |
| 3 | 29.9 | 1.2 | 2 |
| 4 | 11.2 | 5.8 | 3 |

In the abovementioned example, two parameters are used for assigning electrical components to bins. The present disclosure is not limited thereto. In other embodiments, a single parameter is used. Furthermore, the ranges corresponding to the bins are preferably non-overlapping such that only one bin is suitable for an electrical component to be assigned to.

Preferably, the unit cells of the plurality of unit cells are all identical. In addition, the units are preferably arranged in a matrix with a constant pitch between adjacent unit cells in two orthogonal directions.

The unit cells of the plurality of unit cells may each have N component positions, wherein N is an integer equal to or greater than M. When N is greater than M, multiple electrical components belonging to the same bin are arranged within a single unit cell.

The number of electrical components assigned to each bin can be substantially the same for each of the plurality of bins. By properly choosing values for M and N, efficient use of the available electrical components can be realized. For example, if M=5 and N=6, two components of the same bin are arranged in the same unit cell. In this case, it is preferred to use electrical components in the center bin twice, to allow the average performance of the electrical components over the target substrate to be as uniform as possible. For this example, it is therefore preferred if the number of electrical components assigned to this center bin is twice the number of electrical components assigned to any other bin. In other embodiments, for which M=N, it is preferable if substantially the same number of electrical components is assigned to each bin.

Each unit cell may have a rectangular shape but the present disclosure is not limited thereto. Moreover, the component positions can be arranged in a matrix of rows and columns. Each bin can be associated with a performance number, wherein an order of the performance numbers of the bins corresponds to the relative performance of the electrical components assigned to these bins with respect to said one or more parameters. For example, the parameter used for assigning electrical components may be the electrical resistance as measured between two terminals of the electrical component. In this case, the performance parameter of a bin may be the median resistance of that bin. For example, if a bin covers a range between 100 Ohm and 200 Ohm, the median resistance may equal 150 Ohm.

A sum of the performance numbers along a row direction of a unit cell is preferably the same as a sum of the performance numbers along a column direction of that unit cell. For example, the performance numbers of a unit cell with N= 9 and M=3 could be:

| | | |
|---|---|---|
| 1 | 2 | 3 |
| 2 | 3 | 1 |
| 3 | 1 | 2 |

It can be easily verified that the sum of the performance parameters is the same for each column and row. Unit cells and bin selections of this type result in target substrates having a relatively uniform performance of the electrical components.

The performance number associated with a given bin can be proportional or inversely proportional to the measurement value range of this bin. If a bin corresponds to a plurality of parameters, a corresponding plurality of performance numbers can be used. The abovementioned sum along a row and/or column direction of a unit cell is then determined for each performance number individually.

The method may further comprise calculating a homogeneity metric describing the homogeneity of the performance of the electrical components over the target substrate. Calculating the homogeneity metric may comprise computing a local average of the performance number for each component position in a unit cell, the local average corresponding to the average of the performance number at that component position and the performance numbers at neighboring component positions. Next, a standard deviation can be computed of the computed local averages and the homogeneity metric can be determined or calculated in dependence of the computed standard deviation.

The method may preferably comprise selecting the number M of bins and the number N of component positions of the unit cell such that the determined homogeneity metric using these numbers meets a predefined target. Additionally, or alternatively, the method may comprise determining a throughput metric describing a throughput of the transfer process for a given combination of M and N. In this case, M and N can be selected based on the throughput metric and the homogeneity metric. For example, M and N can be selected using the throughput metric such that the determined homogeneity metric meets a predefined target with the highest throughput, or such that weighed sum of the homogeneity metric and throughput metric, using predefined weighing factors, is the highest. The step of determining M and N can be performed prior to the transfer process, for example based on a wafer map.

During the transfer process, electrical components can be selected from the source substrate on a row-by-row basis, preferably by moving from one row of electrical components to an adjacent row of electrical components, preferably in a serpentine manner.

The source substrate may comprise a diced wafer comprising a plurality of semiconductor dies that originate from a same semiconductor wafer, or a structured wafer comprising a plurality of semiconductor dies that originate from different semiconductor wafers.

According to a further aspect of the present disclosure, a pick-and-place apparatus is provided for transferring a plurality of electrical components from a source substrate to a plurality of empty positions on a target substrate. This apparatus comprises a source carrier configured for holding the source substrate, a target carrier configured for holding the target substrate, a transport system configured for collecting an electrical component from the source substrate and for arranging the collected electrical component on the target substrate, and a controller for controlling the transport system, wherein the controller is configured for controlling the transport system to cause the electrical components to be collected from the source substrate and arranged on the target substrate in accordance with the method described above. For example, the controller may comprise a processor and a memory operatively coupled with the processor, wherein the memory comprises a list of instructions, which, when executed by the processor, causes the pick-and-place apparatus to execute the transfer process described above.

The transport system may comprise a source drive for moving the source carrier and a target drive for moving the target carrier, wherein controller is configured to control the source drive and the target drive. In this case, the transport system can be configured to collect the electrical components at a same collect position in space for each electrical component, and/or the transport system can be configured to arrange the collected electrical components at a same placement position in space for each electrical component.

The controller can be configured to control the source drive and/or target drive to repeatedly position an electrical component on the source substrate at the collect position and/or to repeatedly position an empty position on the target substrate at the placement position.

According to a further aspect of the present disclosure, a computer program product is provided that comprises instructions which, when the instructions are executed by the controller of the pick-and-place apparatus described above, cause the controller to control the transport system to cause the electrical components to be collected from the source substrate and arranged on the target substrate in accordance with the method described above.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates a known pick-and-place apparatus;
Figure 2 illustrates an embodiment of a pick-and-place apparatus in accordance with an aspect of the present disclosure;
Figure 3 illustrates the process of assigning electrical components to bins in accordance with an aspect of the present disclosure;
Figure 4 illustrates, on the left, a target substrate having a plurality of positions at which an electrical component can be arranged, and on the right, how this target substate can be filled using electrical components from different bins in accordance with an aspect of the present disclosure;
Figure 5 illustrates different examples of a unit cell in accordance with an aspect of the present disclosure; and
Figure 6 illustrates the computation of a homogeneity metric in accordance with the present disclosure.

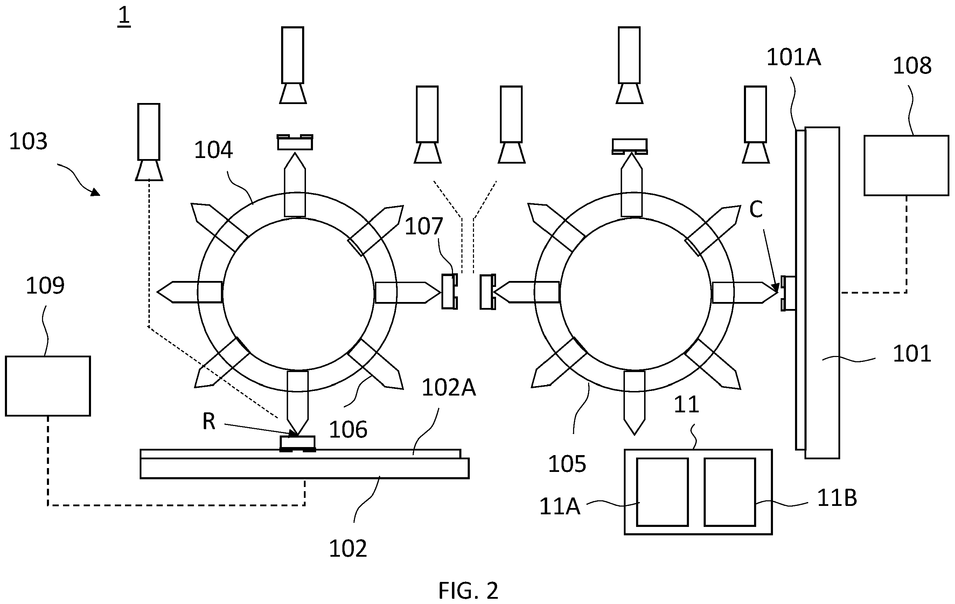

Figure 2 illustrates an embodiment of a pick-and-place apparatus 1 in accordance with an aspect of the present disclosure. It comprises the same components as the known pick-and-place apparatus shown in figure 1. These components are therefore referred to using the same reference signs. However, controller 11 is configured differently from controller 110. According to an aspect of the present disclosure, controller 11 is configured for implementing the method for transferring a plurality of electrical components from a source substrate to a plurality of empty positions on a target substrate in accordance with an aspect of the present disclosure. To this end, controller 11 may comprise a processing unit 11A that is operatively coupled to a memory 11B, wherein memory 11B comprises instructions, which when executed by processing unit 11A, cause the implementation of the method for picking and placing electrical components in accordance with an aspect of the present disclosure.

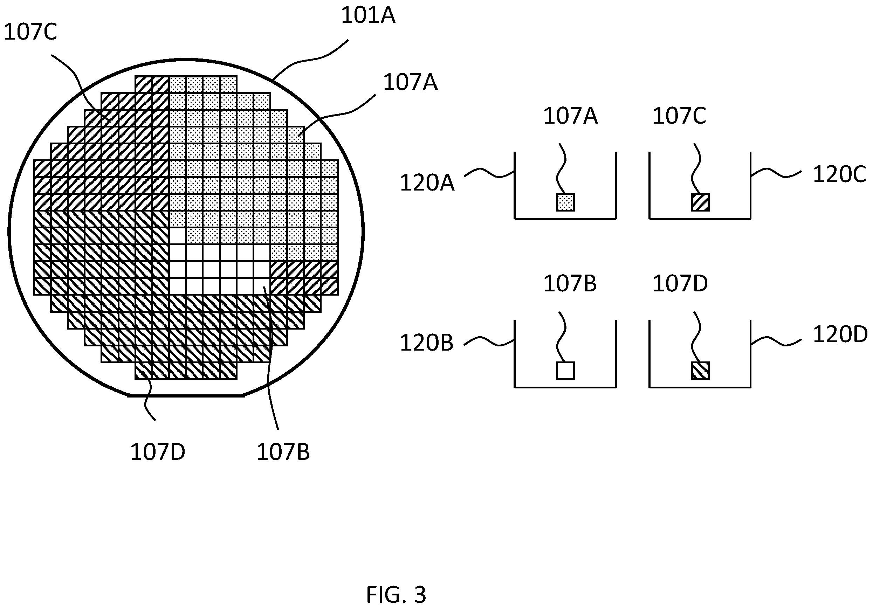

Figure 3 illustrates the process of assigning electrical components to bins in accordance with an aspect of the present disclosure. Here, a source substrate 101A is shown in the form of a diced wafer that comprises a plurality of electrical components 107A-107D. The different hashing used in figure 3 illustrates that electrical components 107A-107D differ with respect to a given parameter. For example, electrical components 107A-107D could comprise LEDs that differ with respect to the intensity of light they emit at given voltage or current levels or that differ with respect to the color temperature of the light they emit.

On the right, figure 3 conceptually illustrates the process of assigning each electrical component 107A-107D to a corresponding performance bin 120A-120D. Performance bins 120A-120D are preferably associated with non-overlapping ranges for the parameter.

Typically, wafer 101A is characterized prior to performing the pick-and-place process. During this characterization, a wafer map is constructed that comprises information on the parameter of each electrical component on wafer 101A. An example entry of the wafer map could be [location semiconductor die on wafer 101A], [measurement value for the parameter].

Assigning electrical components 107A-107D is performed based on the wafer map and results in a so-called binning map. This binning map comprises information about which electrical component 107A-107D is assigned to which bin 120A-120D. An example entry of the binning map could be [location semiconductor die on wafer 101A], [bin number].

The process of assigning electrical components can be performed outside of the pick-and-place apparatus. In this case, controller 11 is configured to receive a binning map and to store the binning map in memory 11B.

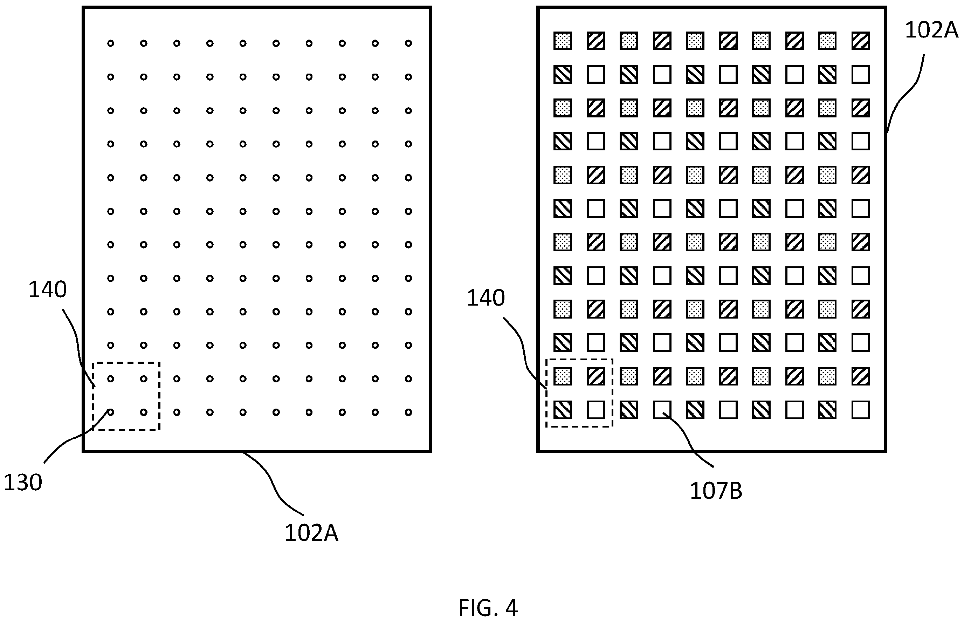

Figure 4 illustrates, on the left, a target substrate 102A having a plurality of component positions 130 at which an electrical component 107A-107D can be arranged, and on the right, how target substate 102A can be filled using electrical components 107A-107D from different bins 120A-120D.

More in particular, according to an aspect of the present disclosure, target substrate 102A is divided into a plurality of unit cells 140, wherein each unit cell 140 comprises a plurality of component positions 130. Furthermore, each component position 130 is associated with a respective bin 120A-120D. According to the present disclosure, electrical components 107A-107D are arranged on target substrate 102A such that, at each component position 130 of each unit cell 140, an electrical component 107A-107D from source substrate 101A is arranged that is assigned to the same bin 120A-120D as the bin that is associated with that component position 130.

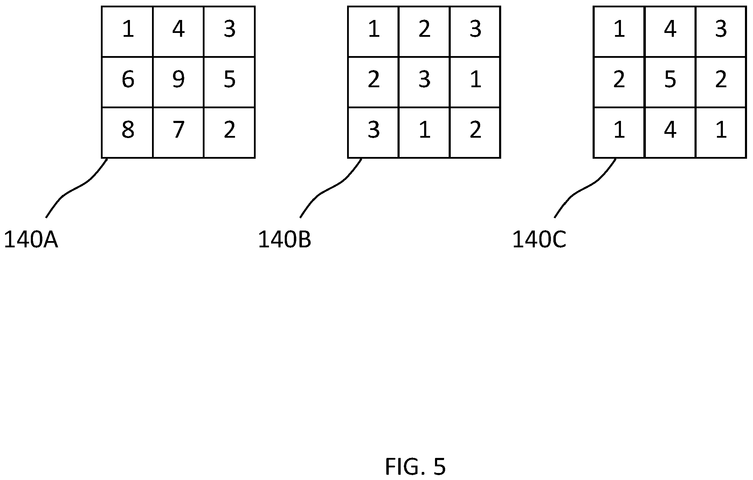

Figure 5 illustrates different examples of a unit cell 104A-104C in accordance with an aspect of the present disclosure. Each unit cell 104A-104C comprises numbers to identify the performance bins. For example, unit cell 140A comprises 9 component positions that are each associated with a different bin among 9 bins. Unit cell 140B comprises 9 component positions that are each associated with a bin among 3 bins, and unit cell 140C comprises 9 component positions that are each associated with a bin among 5 bins. The present disclosure is not limited to a particular number of component positions per unit cell or to a particular number of bins.

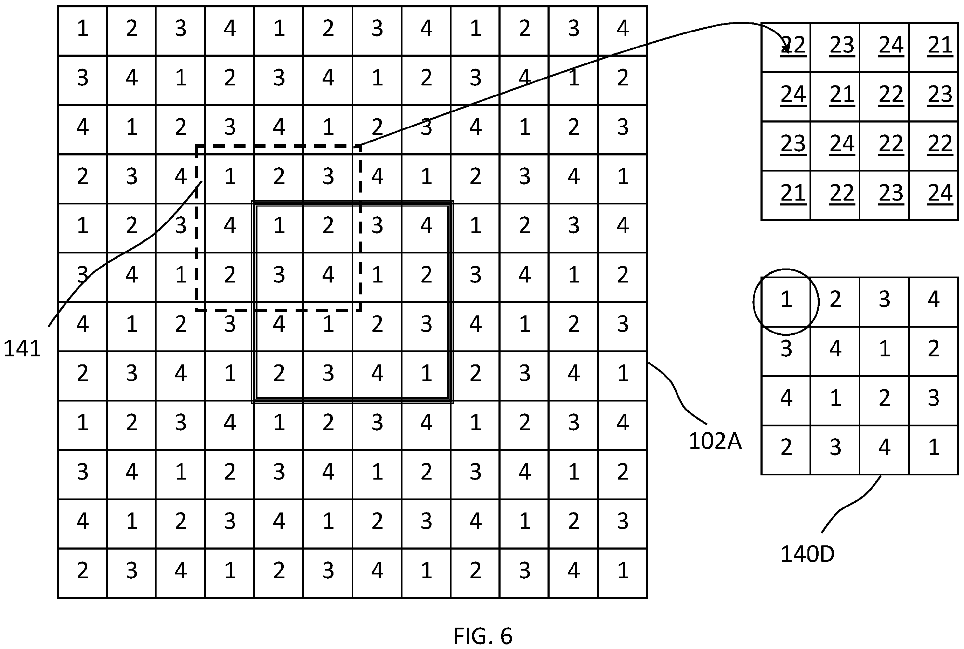

Figure 6 illustrates the computation of a homogeneity metric in accordance with the present disclosure. Here, target substrate 102A is shown divided in a plurality of identical unit cells 140D, shown on the right. Unit cells 140D comprise 16 component positions that are each associated with one out of 4 different performance bins. In figure 6, the numbers associated with the component positions, i.e. the numbers 1-4, are representative for the performance of the electrical components for the associated bins with respect to a parameter and are hereinafter referred to as performance numbers. For example, the performance bins may be generated based on an electrical resistance of the electrical components. In this case, the performance number "1" may indicate a resistance of 1 Ohm, "2" a resistance of 2 Ohm etc. The skilled person will understand that the performance numbers 1-4 are for illustrative purposes only.

Typically, the performance numbers represent an average value of the parameter for a given bin. For example, if the first performance bin corresponds to a range in electrical resistance from 100 to 200 Ohm, the performance number for that performance bin may equal 150 Ohm.

The performance numbers allow an estimation of the uniformity of the parameter over target substrate 102A, even prior to arranging the electrical components. An example thereof is shown on the left in figure 6. This figure illustrates the performance numbers over target substrate 102A and also illustrates a kernel 141 that is used for determining a homogeneity metric that provides an estimation of the uniformity of the performance of the electrical components over target substrate 102A.

In figure 6, kernel 141 is used to determine, for a given component position of unit cell 140D indicated using a circle in the bottom right corner, the sum of the performance number at that component position and the performance numbers of the adjacent 8 component positions. By moving kernel 141 over target substrate 102A, a similar sum can be determined for each component position. The results of this computation are shown in the top right corner.

Using the calculated sums, a homogeneity metric can be determined. For example, a standard deviation of the sums can be determined, which standard deviation can be optionally scaled using the average over kernel 141.

A homogeneity metric can be calculated prior to the pick-and-place process. Furthermore, the homogeneity metric can be used to determine suitable values for the number M of performance bins and the number N of component positions for the unit cells. For example, the homogeneity metric for given combinations of M and N can be compared to a predefined threshold. Among these M and N combinations, that combination can be selected to provide the best uniformity using the homogeneity metric.

The abovementioned homogeneity metric only describes the uniformity of the performance of the electrical component over the target substrate. It does not take into account the throughput that can be obtained using a particular combination of M and N. For example, high numbers of M and N may result in more time-consuming movements of the source carrier and/or target carrier. It may therefore also be possible to determine a different metric, e.g. a throughput metric, which is representative for the throughput of the apparatus. In this case, an overall metric can be determined based on the throughput metric and the homogeneity metric, e.g. a weighted sum, wherein the overall metric is compared to a predefined threshold for determining the most suitable combination of M and N. Alternatively, separate thresholds are used for the throughput metric and homogeneity metric. For example, the most suitable M and N combination is that combination that provides the best uniformity provided that the throughput meets a particular target value.

The abovementioned determination of M and N can be performed for a fixed association between component positions and performance bins, which association is stored in memory 11B or which is provided to controller 11.

Construction of the wafer map is generally performed outside of the pick-and-place apparatus. However, by including a measuring unit in the pick-and-place apparatus, this construction can be performed inside the pick-and-place apparatus. Similarly, the process of constructing a binning map can be performed outside of the pick-and-place apparatus. In this case, the controller receives a binning map on the basis of which the pick-and-place apparatus will collect and arrange electrical components. To this end, information regarding the unit cell to be used, i.e. the size of the unit cells and which bin is associated with which component position, can be provided to the controller. This information may for example be comprised in an information package that also comprises the binning map. In other embodiments, the controller is configured to determine the unit cell to be used in the pick-and-place process. The unit cell size, shape, and which performance bins are associated with which component positions can be determined using a binning map and/or wafer map that is provided to the controller.

In the above, the present invention has been described using detailed embodiments thereof. However, the present invention is not limited to these embodiments. Instead, various modifications are possible without departing from the scope of the present invention which is defined by the appended claims and their equivalents.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalization thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

The term "comprising" does not exclude other elements or steps, the term "a" or "an" does not exclude a plurality. Reference signs in the claims shall not be construed as limiting the scope of the claims.

## Claims

1. A method for transferring a plurality of electrical components from a source substrate to a plurality of empty positions on a target substrate, comprising:
constructing a binning map of the source substrate by assigning each electrical component among the plurality of electrical components to a respective bin among M bins based on one or more parameters of the electrical components, wherein M is greater than 1;
dividing the target substrate into a plurality of unit cells, wherein each unit cell comprises a plurality of component positions, each component position being associated with a respective bin among the plurality of bins;
arranging the electrical components on the target substrate such that, at each component position of each unit cell, an electrical component from the source substrate is arranged that is assigned to the same bin as the bin that is associated with that component position.

2. The method according to claim 1, wherein said constructing a binning map of the source substrate comprises:
measuring one or more parameters of each electrical component among the plurality of components on the source substrate;
for each electrical component among the plurality of components:
comparing measurement values of the one or more parameters to a plurality of preferably non-overlapping ranges for the one or more parameters, each range being associated with a respective bin among the plurality of bins;
associating the electrical component to that bin of which the ranges for the one or more parameters cover the measurement values of the one or more parameters.

3. The method according to claim 1 or claim 2, wherein the one or more parameters include one or more of an electrical resistance, a frequency, wavelength, or colour point of light emitted by the component during operation, and a forward voltage of the component.

4. The method according to any of the previous claims, wherein the unit cells of the plurality of unit cells are all identical.

5. The method according to any of the previous claims, wherein the unit cells of the plurality of unit cells each have N component positions, wherein N is an integer equal to or greater than M.

6. The method according to any of the previous claims, wherein the number of electrical components assigned to each bin is substantially the same for each of the plurality of bins.

7. The method according to any of the previous claims, wherein each unit cell has a rectangular shape, and wherein the component positions are arranged in a matrix of rows and columns;
wherein each bin is associated with a performance number, wherein an order of the performance numbers of the bins corresponds to the relative performance of the electrical components assigned to these bins with respect to the one or more parameters.

8. The method according to claim 7, wherein a sum of the performance numbers along a row direction of a unit cell is the same as a sum of the performance numbers along a column direction of that unit cell, and/or wherein the performance number is proportional or inversely proportional to the measurement value of at least one of the one or more parameters.

9. The method according to any of the claims 7-8, further comprising calculating a homogeneity metric describing the homogeneity of the performance of the electrical components over the target substrate.

10. The method according to claim 9, wherein said calculating the homogeneity metric comprises:
computing a local average of the performance number for each component position in a unit cell, the local average corresponding to the average of the performance number at that component position and the performance numbers at neighboring component positions;
computing a standard deviation of the computed local averages;
determining the homogeneity metric in dependence of the computed standard deviation;
the method preferably further comprising selecting the number M of bins and the number N of component positions of the unit cell such that the determined homogeneity metric using these numbers meets a predefined target and/or determining a throughput metric describing a throughput of the transfer process for a given combination of M and N, wherein M and N are selected based on the throughput metric and homogeneity metric, wherein M and N are preferably selected using the throughput metric such that the determined homogeneity metric meets a predefined target with the highest throughput, or such that weighed sum of the homogeneity metric and throughput metric, using predefined weighing factors, is the highest.

11. The method according to any of the previous claims, wherein, during the transfer process, electrical components are selected from the source substrate on a row-by-row basis, preferably by moving from one row of electrical components to an adjacent row of electrical components, preferably in a serpentine manner.

12. The method according to any of the previous claims, wherein the source substrate comprises a diced wafer comprising a plurality of semiconductor dies that originate from a same semiconductor wafer, or a structured wafer comprising a plurality of semiconductor dies that originate from different semiconductor wafers.

13. A pick-and-place apparatus (1) for transferring a plurality of electrical components (107, 107A-107D) from a source substrate (101A) to a plurality of empty positions (130) on a target substrate (102A), comprising:
a source carrier (101) configured for holding the source substrate;
a target carrier (102) configured for holding the target substrate;
a transport system (103) configured for collecting an electrical component from the source substrate and for arranging the collected electrical component on the target substrate;
a controller (11) for controlling the transport system, wherein the controller is configured for controlling the transport system to cause the electrical components to be collected from the source substrate and arranged on the target substrate in accordance with the method of any of the previous claims.

14. The apparatus according to claim 13, wherein the transport system comprises a source drive (108) for moving the source carrier and a target drive (109) for moving the target carrier, wherein controller is configured to control the source drive and the target drive;
wherein the transport system is configured to collect the electrical components at a same collect position (C) in space for each electrical component, and/or wherein the transport system is configured to arrange the collected electrical components at a same placement position (R) in space for each electrical component;
wherein the controller is configured to control the source drive and/or target drive to repeatedly position an electrical component on the source substrate at the collect position and/or to repeatedly position an empty position on the target substrate at the placement position.

15. A computer program product comprising instructions which, when the instructions are executed by the controller of the pick-and-place apparatus according to claim 13, cause the controller to control the transport system to cause the electrical components to be collected from the source substrate and arranged on the target substrate in accordance with the method of any of the claims 1-12.
